# FASCICULE DE BREVET EUROPEEN

(11) **EP 2 901 551 B1**
(45) Date de publication et mention de la délivrance du brevet: **18.04.2018**
(21) Numéro de dépôt: 13766547.7
(22) Date de dépôt: 26.09.2013
(51) Int. Cl.: H03H 9/17, H03H 9/54, H03H 9/58, H03H 9/02, G10K 11/00

(54) **DISPOSITIF ACOUSTIQUE COMPRENANT UN CRISTAL PHONONIQUE REGLABLE A BASE D'ELEMENTS PIEZOELECTRIQUES**
ELEKTROAKUSTISCHE VORRICHTUNG ENTHALTEND EINEN REGELBAREN PHONONISCHEN KRISTALL MIT PIEZOELEKTRISCHEN ELEMENTEN
ELECTROACOUSTIC DEVICE COMPRISING A CONTROLLABLE PHONONIQUE CRYSTAL USING PIEZOELECTRIC ELEMENTS

(30) Priorité: 27.09.2012 FR 1202561
(43) Date de publication de la demande: 05.08.2015
(73) Titulaire: THALES, 92400 Courbevoie (FR)
(72) Inventeur: PHAM COLOMBAN, Thi Mai, F-94260 Fresnes (FR); ZIAEI, Afshin, F-92170 Vanves (FR); DEGRAEVE, Sébastien, F-59960 Neuville-en-Ferrain (FR); HLADKY-HENNION, Anne-Christine, F-59700 Marcq en Baroeul (FR); DUBUS, Bertrand, F-59790 Ronchin (FR); GRANGER, Christian, F-59650 Villeneuve d'Ascq (FR)
(74) Mandataire: Brunelli, Gérald
(86) Numéro de dépôt international: PCT/EP2013/070052
(87) Numéro de publication internationale: WO 2014/049045

(56) Documents cités:
- EP-A1- 0 874 454
- EP-A2- 1 006 596
- US-A1- 2005 012 568
- US-A1- 2010 321 133
- BOU MATAR O ET AL: "Band gap tunability of magneto-elastic phononic crystal", JOURNAL OF APPLIED PHYSICS, AMERICAN INSTITUTE OF PHYSICS. NEW YORK, US, vol. 111, no. 5, 1 mars 2012 (2012-03-01), pages 54901-54901, XP012158464, ISSN: 0021-8979, DOI: 10.1063/1.3687928 [extrait le 2012-03-01]

## Description

L'invention concerne le domaine des dispositifs acoustiques comprenant des cristaux phononiques et plus particulièrement les cristaux phononiques réglables.

On entend par dispositif acoustique toute structure utilisant la propagation d'ondes acoustiques. De tels dispositifs présentent des fréquences de fonctionnement comprises entre quelques hertz à quelques gigahertz. Les applications potentielles de ces dispositifs peuvent concerner les lentilles acoustiques, des filtres RF pouvant être utilisés dans les communications sans fil et notamment dans la téléphonie mobile, ou bien encore concerner de nombreux dispositifs anti-vibrations.

On entend par cristaux phononiques des structures périodiques composées de matériaux de propriétés élastiques distinctes modifiant la propagation des ondes acoustiques. Dans des domaines de fréquences donnés, les ondes acoustiques se propagent, en dehors de ces domaines, les ondes acoustiques ne se propagent pas.

L'absence de propagation d'ondes acoustiques sur un intervalle de fréquences donné est qualifiée de bande de fréquences interdites ou band gap en langue anglaise.

Il existe deux types de bandes de fréquences interdites : les bandes interdites dites de Bragg et les bandes interdites dite d'hybridation.

Les bandes interdites dites de Bragg sont observées pour des cristaux phononiques généralement constitués par une organisation périodique de plusieurs et le plus souvent de deux matériaux acoustiquement différents. Ces organisations peuvent être à une, deux voire trois dimensions. Les structures à une dimension correspondent aux miroirs de Bragg.

Selon un art connu, ces structures sont généralement réalisées en superposant des couches de matériaux différents.

Selon un autre art connu, ces structures sont généralement réalisées en creusant des trous dans un matériau selon un motif élémentaire périodique et parfois en remplissant les trous partiellement ou complètement d'un autre matériau.

Les bandes interdites dites d'hybridation sont liées à un mode de résonateur, lorsque la structure comporte des résonateurs périodiquement espacés. La position en fréquence de la bande interdite d'hybridation dépend de la fréquence de résonance du résonateur et non de la périodicité du réseau.

Les cristaux phononiques développés actuellement ont une réponse définie dès leur élaboration. En d'autres termes, les bandes de fréquences interdites sont déterminées dès leur conception : les matériaux, le motif d'arrangement élémentaire des inclusions et la géométrie du cristal déterminent de manière définitive la fréquence centrale et la largeur en fréquence des bandes interdites.

L'un des paramètres importants dans le domaine des cristaux phononiques est la largeur en fréquence de la bande interdite. Généralement, on cherche à obtenir des bandes interdites les plus larges possibles en fréquence.

Selon un art antérieur, dans le cas d'une structure multicouche, il est possible d'élargir la bande interdite en augmentant le contraste des impédances acoustiques, l'impédance acoustique étant définie par le produit de la vitesse de propagation et de la densité dans le milieu entre deux couches successives.

Selon un art antérieur, dans le cas des structures périodiques comportant des inclusions, il est possible d'élargir la bande interdite en augmentant le diamètre des inclusions mais on atteint rapidement des limites technologiques. La miniaturisation des dimensions des composants entraîne une complexification des étapes technologiques et une augmentation des coûts.

Dans ce contexte, la présente invention propose une solution permettant de contrôler la fréquence centrale mais aussi la fréquence des bornes supérieure et inférieure des bandes de fréquences interdites, autrement dit la largeur en fréquence des bandes interdites.

Selon un aspect de l'invention, il est proposé un dispositif acoustique comprenant une structure périodique phononique à bande réglable de fréquences interdites de charge comprenant :
- un ensemble d'éléments piézoélectriques connectés mécaniquement en série, un élément piézoélectrique comprenant un matériau piézoélectrique et étant polarisé selon une direction de polarisation (dₚₒₗ), les directions de polarisation de deux éléments successifs étant parallèles ou anti-parallèles et lesdits éléments piézoélectriques étant dirigés selon une direction principale (d_{princ});
- un ensemble d'électrodes disposées entre deux éléments piézoélectriques adjacents et perpendiculaires à la direction principale ; l'ensemble desdites électrodes comprenant au moins un sous-ensemble d'électrodes connectées de façon périodique à une référence électrique extérieure, ledit sous-ensemble d'électrodes étant connecté à la référence électrique par l'intermédiaire d'un circuit électrique.

Selon l'invention, la bande réglable de fréquences interdites apparait lorsqu'un déplacement de charges électriques provient d'une référence électrique extérieure via une électrode dudit ensemble d'électrodes.

La périodicité d'une condition électrique, par la périodicité des électrodes, imposée à la série d'éléments crée un déplacement des charges vers l'électrode qui génère un nouveau type de bandes interdites appelées bandes de fréquences interdites de charge ou de potentiel.
Selon un autre aspect de l'invention, le circuit électrique comprend, par exemple, une résistance et/ou une capacité et/ou une inductance.
La connexion de l'électrode à la référence électrique par l'intermédiaire d'un circuit électrique permet de déplacer en fréquence les bornes supérieure et inférieure de la bande interdite de charge, rendant les bandes interdites de charge réglables en fréquence.
Avantageusement, le dispositif acoustique tel que décrit précédemment est adapté pour commander le circuit électrique à partir de données reçues d'un capteur extérieur ce qui permet une commande en temps réel.

Selon une variante de l'invention, l'ensemble d'éléments comprend un sous-ensemble d'éléments répété périodiquement. Ce sous-ensemble permet de sélectionner la position en fréquence de la bande interdite de charge créée.

Selon une variante de l'invention, les éléments piézoélectriques comprennent un même matériau piézoélectrique.

Selon une autre variante de l'invention, la série d'éléments comprend en outre au moins un élément diélectrique.

Selon une variante de l'invention, la référence électrique est la masse. Alternativement, la référence électrique est une source extérieure de tension.

Les éléments piézoélectriques et diélectriques ont une forme de plaques. Alternativement, les éléments piézoélectriques et diélectriques ont une forme de tronçons, les tronçons pouvant être cylindriques ou annulaires.

La direction principale est la direction du cristal phononique. Les électrodes sont perpendiculaires à la direction principale. La polarisation électrique doit être parallèle ou antiparallèle à la direction principale. La direction de propagation de l'onde acoustique peut être parallèle à la direction principale ou oblique, la polarisation de l'onde acoustique pouvant être diverse.

Selon un autre aspect de l'invention, il est proposé un résonateur BAW ou Bulk Acoustic Waves en langue anglaise comprenant un dispositif acoustique tel que décrit précédemment.

Selon un autre aspect de l'invention, il est proposé un dispositif à cavité résonante comprenant un dispositif phononique à bande de fréquences interdites de charge telle que décrit précédemment ce qui permet de régler la fréquence de résonance de la cavité.

Selon un autre aspect de l'invention, il est proposé un dispositif d'isolation d'une structure vibrante comprenant un dispositif phononique à bande de fréquences interdites de charge tel que décrit précédemment.

Avantageusement, le dispositif d'isolation comprend une structure d'amortissement.

Selon un autre aspect de l'invention, il est proposé un dispositif de transfert d'énergie d'une première structure vibrante vers une deuxième structure vibrante comprenant un dispositif phononique à bandes de fréquences interdites de charge tel que décrit précédemment.

L'invention sera mieux comprise à l'étude de quelques modes de réalisation décrits à titre d'exemples nullement limitatifs, et illustrés par des dessins annexés sur lesquels :

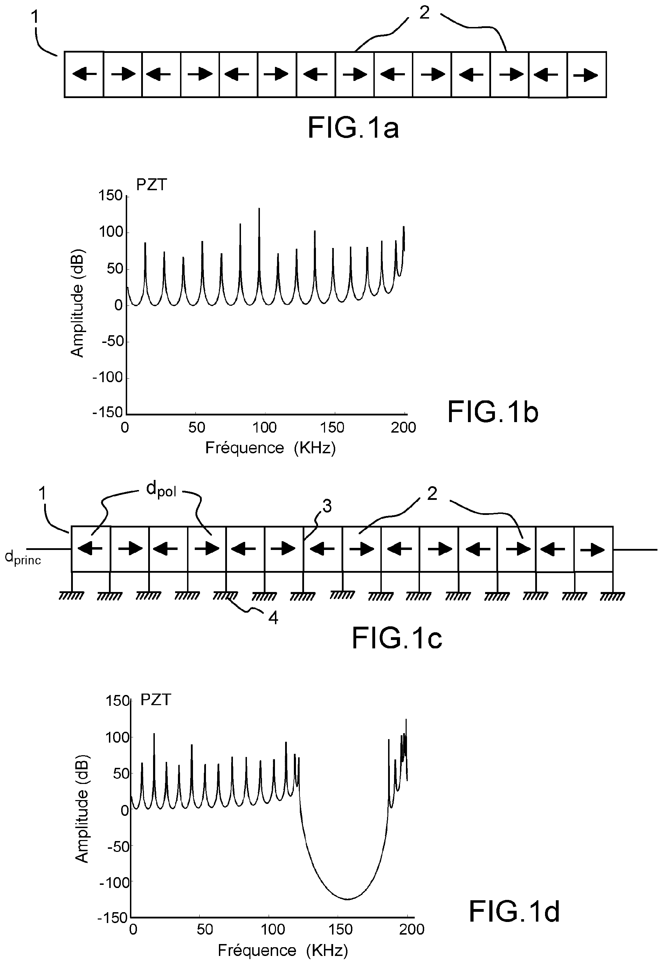

- la figure 1a représente une série de quatorze éléments comprenant du PZT, les sens de polarisation de deux éléments successifs sont opposés et aucune des électrodes n'est connectée à la masse, selon un aspect de l'invention,
- la figure 1c représente une série de quatorze éléments comprenant du PZT, les sens de polarisation de deux éléments successifs sont opposés et toutes les électrodes sont connectées à la masse, selon un aspect de l'invention,

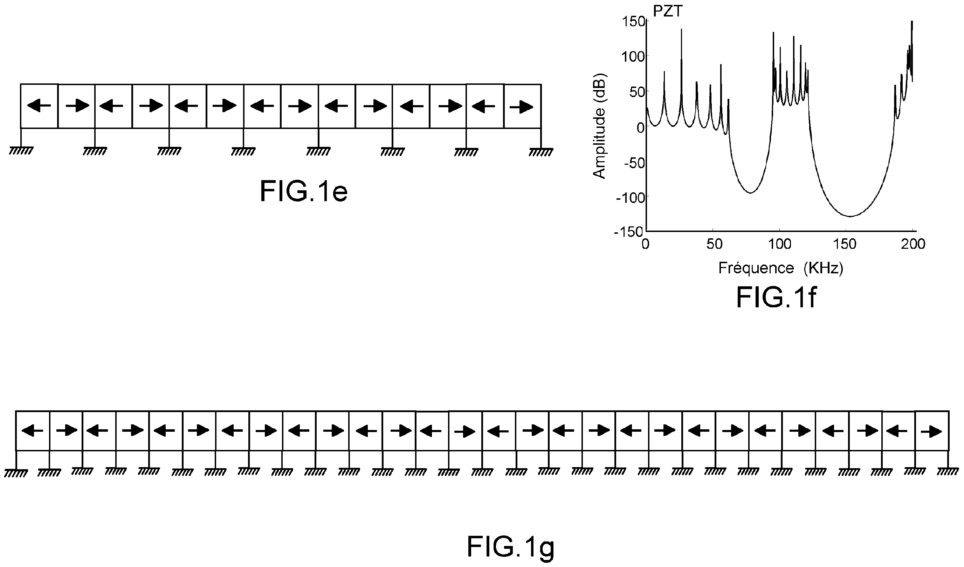

- la figure 1e représente une série de quatorze éléments comprenant du PZT, les sens de polarisation de deux éléments successifs sont opposés et une électrode sur deux est connectée à la masse, selon un aspect de l'invention,
- la figure 1g représente une série de vingt-huit éléments comprenant du PZT, les sens de polarisation de deux éléments successifs sont opposés et toutes les électrodes sont connectées à la masse, selon un aspect de l'invention,
- la figure 1b, la figure 1d, la figure 1f et la figure 1h représentent les courbes calculées du signal transmis associées aux modes de réalisation présentés sur les figures 1a, 1c, 1e et 1g, respectivement,
- la figure 2a représente une série de quatorze éléments comprenant du PZT, les sens de polarisation de deux éléments successifs sont opposés et aucune des électrodes n'est connectée à la masse, selon un aspect de l'invention,
- la figure 2c représente une série de quatorze éléments comprenant du PZT, les sens de polarisation de deux éléments successifs sont opposés et une électrode sur deux est connectée à la masse, selon un aspect de l'invention,
- la figure 2e représente une série de quatorze éléments comprenant du PZT, les sens de polarisation de deux éléments successifs sont opposés et une électrode sur deux est connectée à la masse, les autres électrodes sont connectées à la masse via une capacité, selon un aspect de l'invention,
- la figure 2g représente une série de quatorze éléments comprenant du PZT, les sens de polarisation de deux éléments successifs sont opposés et une électrode sur deux est connectée à la masse via une capacité, selon un aspect de l'invention,

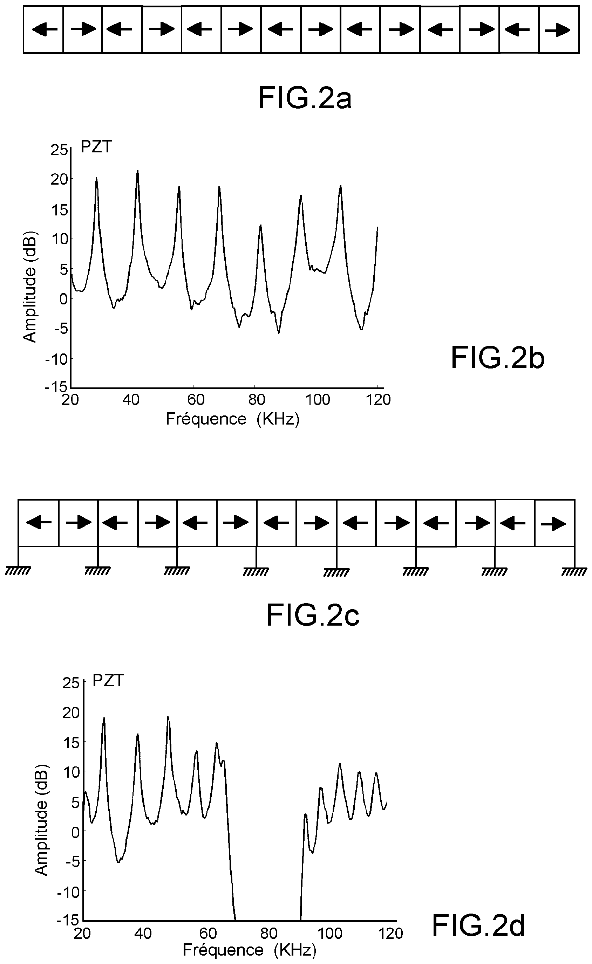

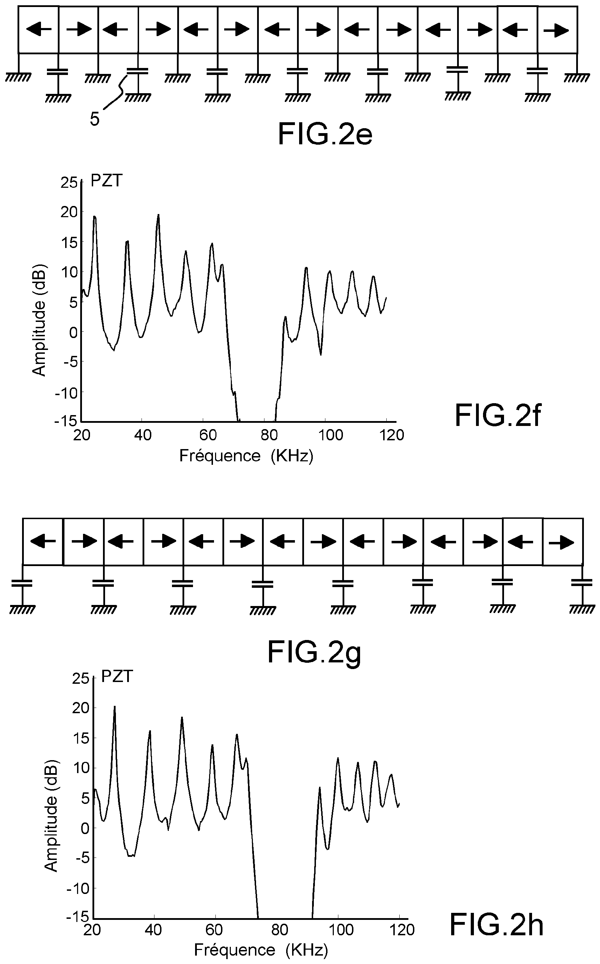

- la figure 2b, la figure 2d, la figure 2f et la figure 2h représentent les courbes mesurées du signal transmis associées aux modes de réalisation présentés sur les figures 2a, 2c, 2e et 2g, respectivement,

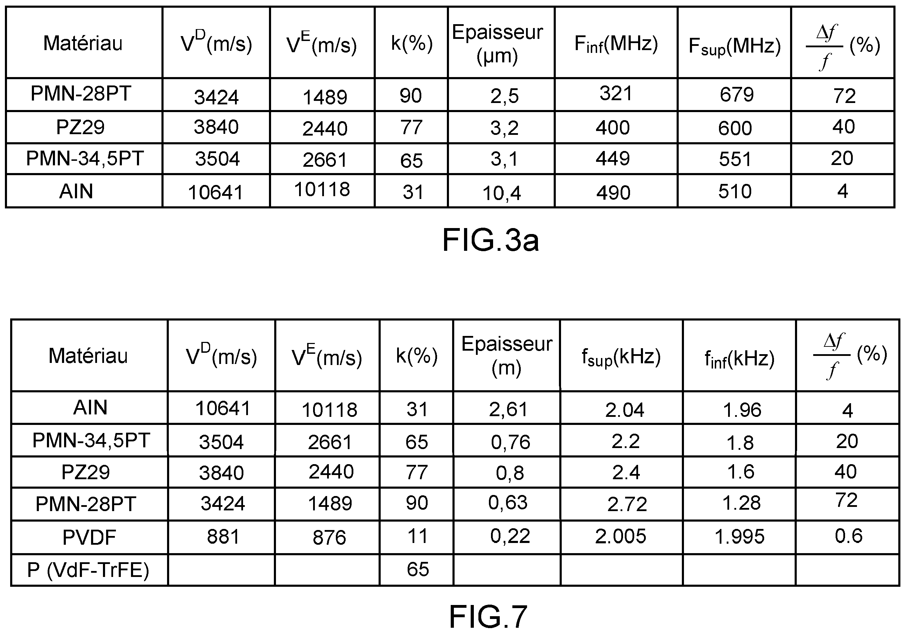

- la figure 3a représente un tableau présentant une liste de matériaux piézoélectriques ainsi que les valeurs de leurs caractéristiques intrinsèques, en l'espèce les séries d'éléments sont en circuit fermé, toutes les électrodes sont connectées à la masse,

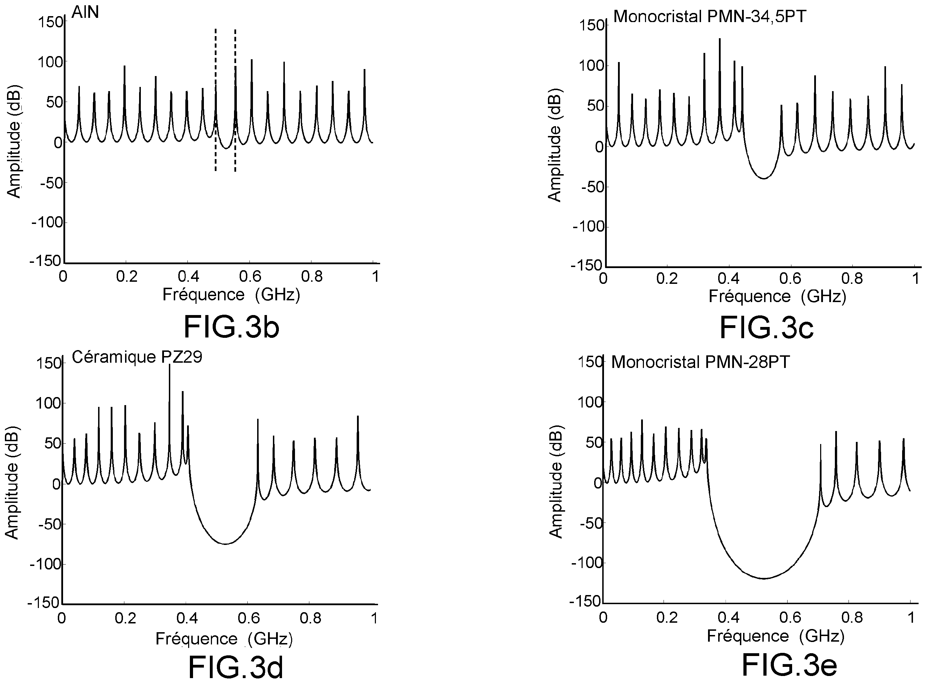

- les figures 3b à 3e représentent les courbes calculées du signal transmis des différents matériaux piézoélectriques listés dans le tableau de la figure 3a,

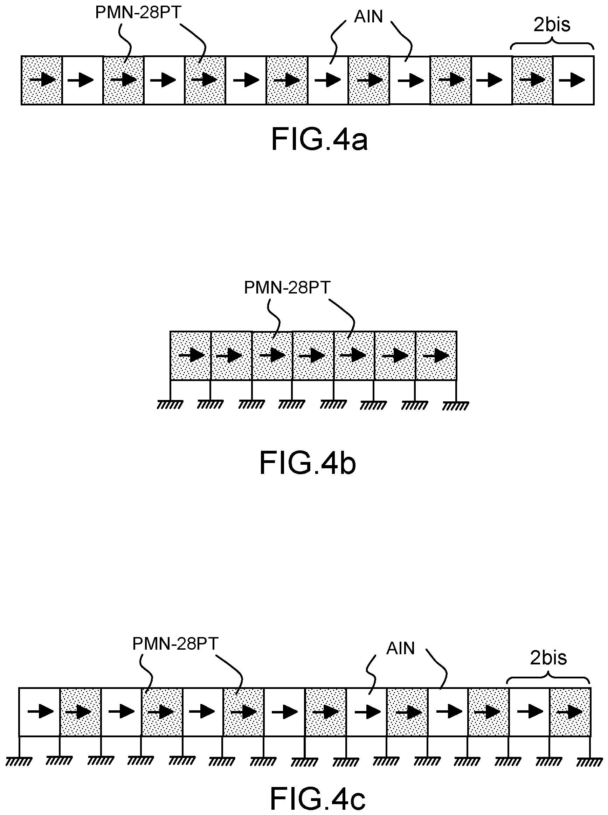

- la figure 4a représente une série de sept sous-ensembles constituant un élément et comprenant une alternance de PMN-28PT et de AIN, le sens de polarisation de deux éléments successifs est identique, aucune électrode n'est connectée à la masse, selon un autre aspect de l'invention,
- la figure 4b représente un ensemble de sept éléments comprenant uniquement du PMN-28PT, le sens de polarisation de deux éléments successifs est identique, toutes les électrodes sont connectées à la masse, selon un aspect de l'invention,

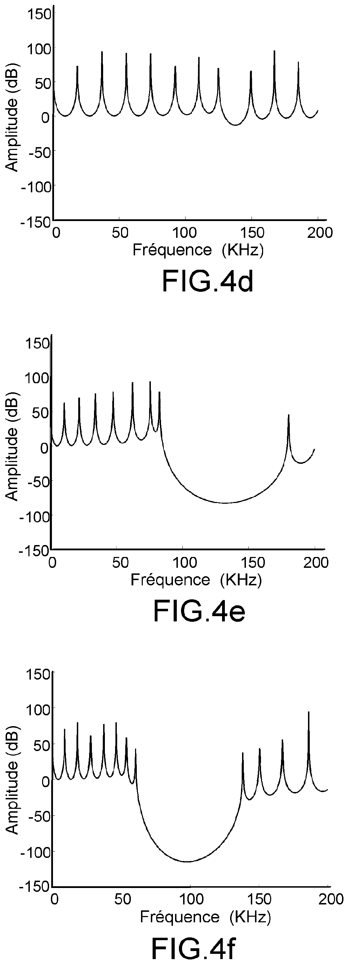

- la figure 4c représente une série de sept sous-ensembles constituant un élément et comprenant une alternance de PMN-28PT et de AIN, le sens de polarisation de deux éléments successifs est identique, toutes les électrodes sont connectées à la masse, selon un aspect de l'invention, les figures 4d, 4e et 4f représentent les courbes calculées du signal transmis associées aux modes de réalisation présentés sur les figures 4a, 4b et 4c,

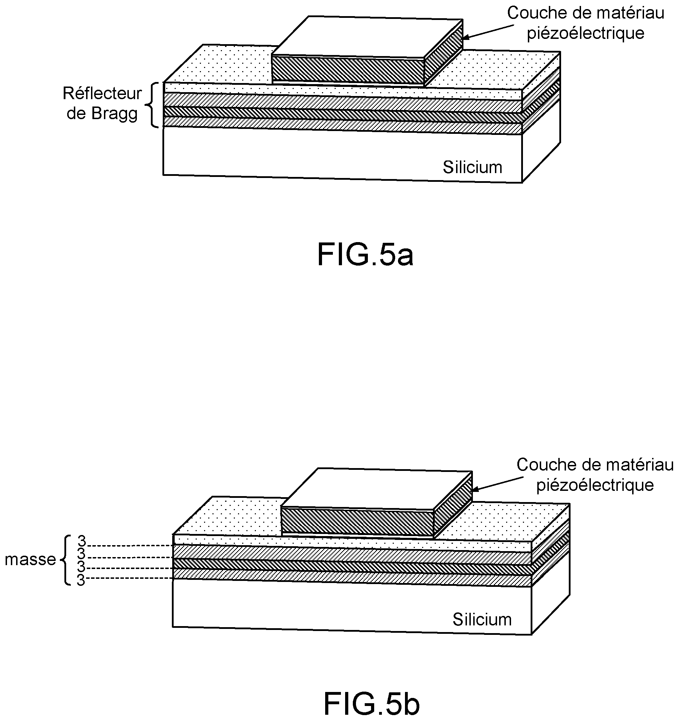

- la figure 5a représente le schéma de principe d'un résonateur BAW, selon l'art connu,
- la figure 5b représente le schéma de principe d'un résonateur BAW selon un aspect de l'invention,

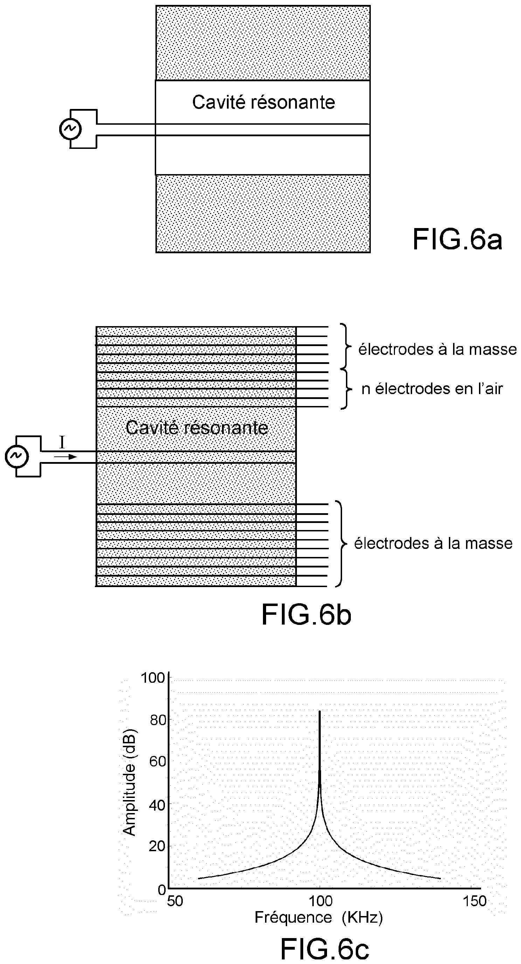

- la figure 6a représente un schéma d'un dispositif à cavité résonante dans lequel l'excitation est située à l'intérieur de la cavité, selon l'art connu,
- la figure 6b représente un schéma d'un dispositif à cavité résonante intégrant une structure phononique à bande de fréquences interdites de charge, selon un aspect de l'invention,
- la figure 6c représente l'impédance d'entrée d'une cavité résonante en fonction de la fréquence, selon l'art connu,
- la figure 7 représente un tableau représentant une liste de matériaux, leurs caractéristiques intrinsèques ainsi que l'épaisseur nécessaire pour générer une bande de fréquences interdites de charge à 2 kHz, selon un aspect de l'invention,

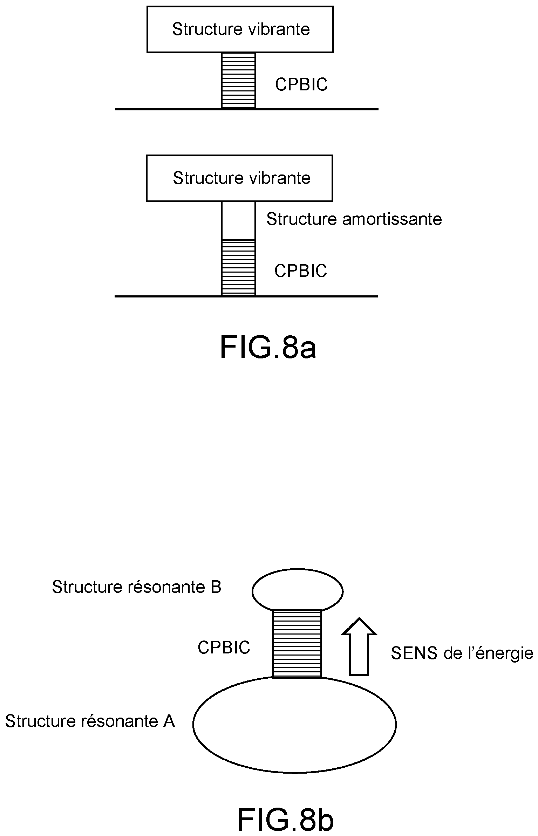

- la figure 8a illustre une structure phononique à bande de fréquences interdites de charge utilisée pour isoler une structure vibrante d'une autre, selon un aspect de l'invention,
- la figure 8b illustre une structure phononique à bande de fréquences interdites de charge utilisée pour transférer l'énergie vibratoire d'une structure vers une autre, selon un aspect de l'invention,

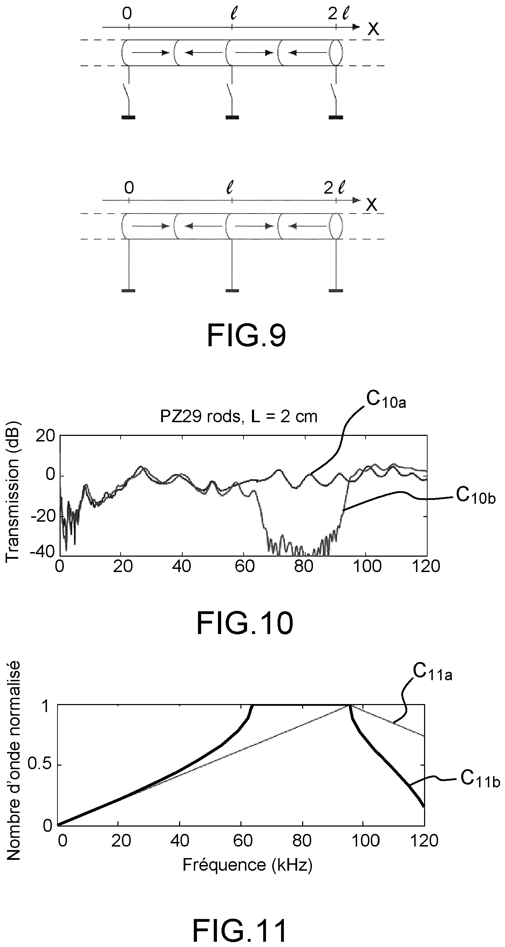

- la figure 9 illustre le passage des électrodes en circuit ouvert à des électrodes en court-circuit dans un exemple de dispositif de l'invention dont la longueur L représentée est égale à 2 cm,
- la figure 10 illustre l'évolution de la transmission en fonction de la fréquence pour les deux configurations représentées en figure 9,
- la figure 11 illustre l'évolution du nombre d'onde normalisé en fonction de la fréquence pour les deux configurations représentées en figure 9,

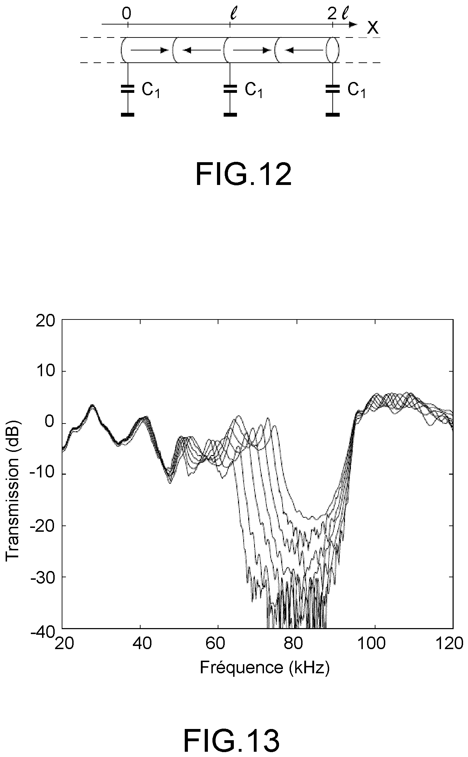

- la figure 12 illustre une configuration de dispositif de l'invention comprenant des capacités placées à la place des court-circuits,
- la figure 13 illustre l'évolution de la transmission en fonction de la fréquence pour la configuration représentée en figure 12 et pour différentes valeurs de la capacité C1,

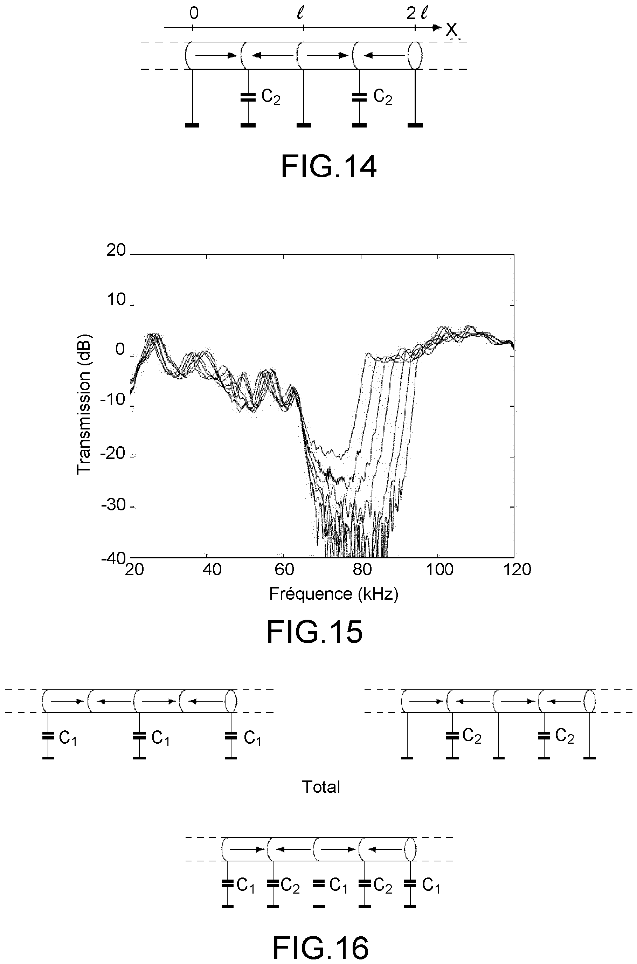

- la figure 14 illustre une configuration de dispositif de l'invention comprenant des capacités et des courts circuits en alternance,
- la figure 15 illustre l'évolution de la transmission en fonction de la fréquence pour la configuration représentée en figure 14 et pour différentes valeurs de la capacité C2,
- la figure 16 illustre une configuration de dispositif de l'invention comprenant une combinaison des configurations représentées en figure 12 et en figure 14,

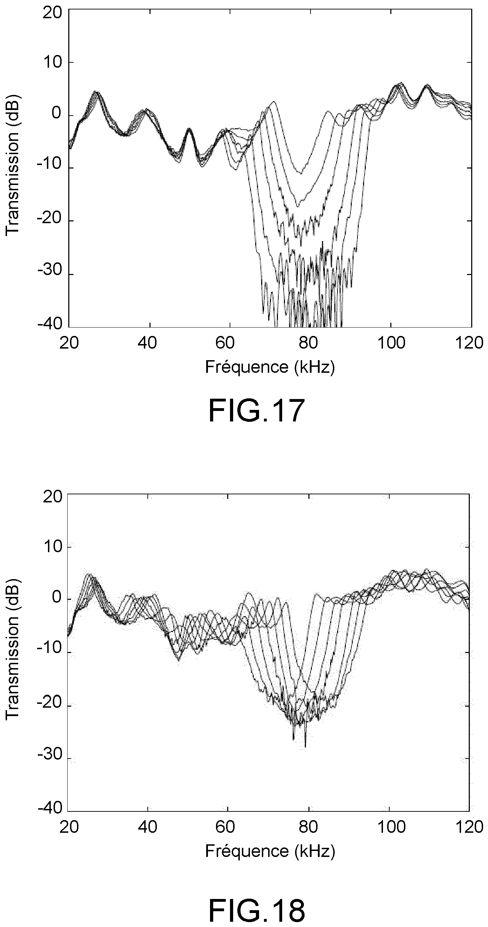

- la figure 17 illustre l'évolution de la transmission en fonction de la fréquence pour la configuration représentée en figure 16 et pour différentes valeurs des capacités C1 et C2, dans laquelle la largeur de la bande interdite est modifiée sans modifier la fréquence centrale,
- La figure 18 illustre l'évolution de la transmission en fonction de la fréquence pour la configuration représentée en figure 16, et pour différentes valeurs des capacités C1 et C2, dans laquelle la largeur de la bande interdite n'est pas modifiée, la fréquence centrale l'étant.

La courbe du signal transmis d'une structure périodique représente l'amplitude du signal transmis en décibel (dB) en fonction de la fréquence pour une direction donnée. Ces courbes permettent d'identifier les bandes passantes correspondant aux intervalles de fréquences dans lesquelles les ondes se propagent et les bandes de fréquences interdites dans lesquelles les ondes ne se propagent pas. Les bandes interdites sont des intervalles de fréquences dans lesquelles les ondes sont évanescentes, autrement dit, ce sont des intervalles de fréquences dans lesquelles l'amplitude des ondes acoustiques diminue exponentiellement avec la distance.

Il existe deux types de bandes interdites : les bandes interdites de Bragg et les bandes interdites d'hybridation. Les bandes interdites de Bragg dépendent des matériaux constituant la matrice et des inclusions du cristal phononique, de la géométrie et du type d'arrangement élémentaire. Les bandes interdites de Bragg sont définies définitivement au moment de la conception du cristal phononique. Les bandes interdites d'hybridation sont liées à un mode d'un résonateur lorsque la structure comporte des résonateurs périodiquement espacés.

L'invention propose de créer un nouveau type de bandes interdites, appelées bandes de fréquences interdites de charge ou de potentiel. Les bandes de fréquences interdites de charge ou de potentiel apparaissent uniquement lorsqu'il y a un déplacement de charges électriques provenant de l'extérieur vers l'électrode.

Les figures 1a à 1f représentent des modes de réalisation de l'invention. Elles illustrent l'apparition de bandes de fréquences interdites de charge ou de potentiel.

La figure 1a représente une structure 1 comprenant un ensemble de quatorze éléments 2 mécaniquement connectés comprenant le même matériau piézoélectrique. En l'espèce, le matériau piézoélectrique comprend du titano-zirconate de plomb ou PZT de formule chimique Pb(ZrₓTi₁₋ₓ)O₃, les éléments 2 ayant une forme de tronçons. On entend par tronçon une forme géométrique en trois dimensions dont la hauteur est supérieure ou égale à la plus grande dimension de la base. En l'espèce, les tronçons sont de forme cylindrique de 1 cm de diamètre et de 1 cm de hauteur. Les éléments 2 sont connectés entre eux par l'intermédiaire d'électrodes 3 et polarisés perpendiculairement aux électrodes 3. En l'espèce, les polarisations de deux éléments 2 du matériau piézoélectrique successifs sont opposées et le dispositif est en circuit ouvert, autrement dit, aucune des électrodes 3 n'est connectée à la référence électrique 4.

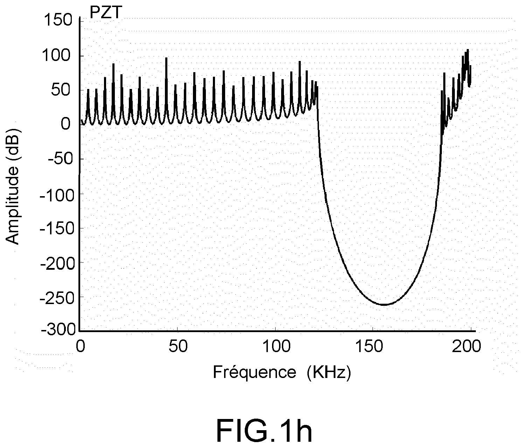

La figure 1b est une représentation graphique du signal transmis en décibel d'une onde acoustique à l'intérieur de la série d'éléments 2 telle que décrite sur la figure 1a en fonction de la fréquence, l'intervalle de fréquence étudié étant compris entre 0 et 200 kHz. L'onde acoustique se propage sur tout l'intervalle de fréquences étudié, aucune bande de fréquences interdites de charge n'apparaît. La série de matériau piézoélectrique telle que décrite sur la figure 1a est considérée comme homogène d'un point de vue du déplacement des charges électriques. Par ailleurs, si la polarisation du matériau piézoélectrique des éléments 2 est dans le même sens, la courbe du signal transmis obtenue est identique à la courbe du signal transmis représentée sur la figure 1 b.

Le type de polarisation, tous dans le même sens ou en sens opposé des éléments 2 n'a pas d'influence sur la présence ou non de bandes interdites de charge.

La figure 1c représente un ensemble de quatorze éléments 2 comprenant le même matériau piézoélectrique. Un tronçon de matériau piézoélectrique comprend du titano-zirconate de plomb ou PZT de formule chimique Pb(ZrₓTi₁₋ₓ)O₃. En l'espèce, les éléments 2 de matériau piézoélectrique sont de forme cylindrique de 1 cm de diamètre et de 1 cm de hauteur. Les éléments 2 sont connectés entre eux par l'intermédiaire d'électrodes 3 et polarisés perpendiculairement aux électrodes. La direction de polarisation dₚₒₗ est identique à la direction principale d_{princ} des éléments (2). Les polarisations du matériau piézoélectrique de deux éléments 2 successifs sont opposées et le dispositif est en circuit fermé. En l'espèce, toutes les électrodes 3 sont directement connectées à la masse.

La figure 1d est une représentation graphique du signal transmis en décibel d'une onde acoustique à l'intérieur de l'ensemble d'éléments 2 tel que décrit sur la figure 1c en fonction de la fréquence, l'intervalle de fréquence étudié étant compris entre 0 et 200 kHz.

Dans un intervalle de fréquence compris entre 125 et 175 kHz, le signal transmis chute brutalement pour atteindre un minimum inférieur à -130 dB à 150 kHz. Dans cet intervalle de fréquences, les ondes acoustiques sont très fortement atténuées. Cet intervalle de fréquence correspond à une bande de fréquences interdites de charge selon un aspect de l'invention.

Une condition électrique périodique est imposée à la série d'éléments 2 telle que décrite sur la figure 1a. En l'espèce, cette condition électrique périodique est une mise à la masse de toutes les électrodes 3 générant ainsi un déplacement de charges électriques ce qui engendre l'apparition d'une bande de fréquences interdites de charge selon le principe de l'invention.

Par ailleurs, si la polarisation du matériau piézoélectrique des éléments 2 successifs est dans le même sens, la courbe du signal transmis obtenue est identique à la courbe du signal transmis représentée sur la figure 1d. Le type de polarisation, dans le même sens ou en dans des sens opposés du matériau piézoélectrique des éléments 2 n'a pas d'influence sur la présence ou non de bandes de fréquences interdites de charge. Autrement dit, lorsque les sens de polarisation des éléments 2 entre deux conditions électriques est identiques alors l'orientation de la polarisation n'a pas d'influence sur les caractéristiques des bandes de fréquences interdites de charge générées.

La figure 1e représente une série de quatorze éléments 2 comprenant le même matériau piézoélectrique. Un tronçon de matériau piézoélectrique comprend du titano-zirconate de plomb ou PZT de formule chimique Pb(ZrₓTi₁₋ₓ)O₃. En l'espèce, les éléments 2 de matériau piézoélectrique sont de forme cylindrique de 1 cm de diamètre et de 1 cm de hauteur. Les éléments 2 sont connectés entre eux par l'intermédiaire d'électrodes 3 et polarisés perpendiculairement aux électrodes. La polarisation du matériau piézoélectrique des éléments 2 successifs est en sens opposé et une électrode sur deux est en circuit fermé. En l'espèce, une électrode sur deux est connectée à la masse.

La figure 1f est une représentation graphique du signal transmis en décibel d'une onde acoustique à l'intérieur de la série d'éléments 2 telle que décrite sur la figure 1e en fonction de la fréquence, l'intervalle de fréquence étudié étant compris entre 0 et 200 kHz.

Dans un intervalle de fréquence compris entre 125 et 175 kHz, le signal transmis chute brutalement pour atteindre un minimum inférieur à -130 dB à 150 kHz. Dans cet intervalle de fréquences, les ondes acoustiques sont très fortement atténuées. Cet intervalle de fréquence correspond à une première bande interdite de charge déjà présente dans le cas précédent. Dans un intervalle de fréquences compris entre 50 et 100 kHz, le signal transmis chute à nouveau brutalement pour atteindre un minimum inférieur à -95 dB à 75 kHz. Dans cet intervalle de fréquences, les ondes acoustiques sont très atténuées. Cet intervalle de fréquence correspond à une deuxième bande de fréquences interdites de charge.

Les figures 1a à 1f mettent en évidence l'apparition de bandes de fréquences interdites de charge en fonction de la condition électrique périodique imposée. Ces figures montrent qu'il est possible de générer des bandes interdites supplémentaires.

La figure 1g représente un ensemble de vingt-huit éléments 2 comprenant le même matériau piézoélectrique. Un tronçon de matériau piézoélectrique comprend du titano-zirconate de plomb ou PZT de formule chimique Pb(ZrₓTi₁₋ₓ)O₃. En l'espèce, les éléments 2 de matériau piézoélectrique sont de forme cylindrique de 1 cm de diamètre et de 1 cm de hauteur. Les éléments 2 sont connectés entre eux par l'intermédiaire d'électrodes 3 et polarisés perpendiculairement aux électrodes. Les polarisations du matériau piézoélectrique de deux éléments 2 successifs sont opposées et le dispositif est en circuit fermé. En l'espèce, toutes les électrodes 3 sont directement connectées à la masse.

La figure 1h est une représentation graphique du signal transmis en décibel d'une onde acoustique à l'intérieur de l'ensemble d'éléments 2 tel que décrit sur la figure 1g en fonction de la fréquence, l'intervalle de fréquence étudié étant compris entre 0 et 200 kHz.

Dans un intervalle de fréquence compris entre 125 et 175 kHz, le signal transmis chute brutalement pour atteindre un minimum inférieur à -260 dB à 150 kHz. Dans cet intervalle de fréquences, les ondes acoustiques sont très fortement atténuées. Cet intervalle de fréquence correspond à une bande de fréquences interdites de charge selon un aspect de l'invention.

La figure 1g et la figure 1h mettent en évidence l'influence du nombre d'éléments 2. L'augmentation du nombre d'éléments 2 augmente l'atténuation du signal transmis dans une bande de fréquences interdites de charge.

Dans un autre mode de réalisation, non représenté, une série de quatorze éléments 2 comprend le même matériau piézoélectrique comprenant du titano-zirconate de plomb ou PZT de formule chimique Pb(ZrₓTiᵢ₋ₓ)O₃ sous forme de tronçons cylindriques de 1 cm de diamètre et de 1 cm de hauteur, les éléments 2 sont connectés entre eux par l'intermédiaire d'électrodes 3 et polarisés perpendiculairement aux électrodes. La polarisation du matériau piézoélectrique de deux éléments 2 successifs est dans le même sens et une électrode sur trois est en circuit fermé. En l'espèce, une électrode sur trois est connectée à la masse. Une bande de fréquences interdites de charge de fréquence centrale de 50 kHz apparaît.

Le changement du sens d'orientation de la polarisation d'un élément sur deux et le changement de condition électrique permet de déplacer et/ou de créer des bandes de fréquences interdites de charge.

Ce dernier mode de réalisation montre qu'il est possible de déplacer la fréquence centrale d'une bande de fréquences interdites de charge en modifiant la condition périodique électrique imposée et le sens de polarisation des éléments 2 entre deux conditions électriques.

Les figures 2a à 2h représentent des modes de réalisation de l'invention ainsi que les courbes du signal transmis associées. Ces figures illustrent la possibilité de déplacer en fréquence les bornes supérieure et inférieure des bandes interdites de charge générées en imposant une condition électrique plus complexe qu'une simple mise à la masse.

La figure 2a représente une série de quatorze éléments 2 comprenant le même matériau piézoélectrique. Le mode de réalisation de la figure 2a est le même que celui de la figure 1a.

En l'espèce, les polarisations du matériau piézoélectrique de deux éléments 2 successifs sont opposées et le dispositif est en circuit ouvert.

La figure 2b est une représentation graphique du signal transmis d'une onde acoustique à l'intérieur de la série d'éléments 2 telle que décrite sur la figure 2a en fonction de la fréquence, l'intervalle de fréquence étudié étant compris entre 0 et 120 kHz.

Comme sur la figure 1b aucune bande interdite de charge n'apparaît. La série d'éléments 2 connectés est considérée comme homogène d'un point de vue du déplacement des charges.

La figure 2c correspond au mode de réalisation de la figure 1e, une électrode sur deux est connectée à la masse.

La figure 2d représente la courbe du signal transmis en fonction de la fréquence sur un intervalle de fréquence compris entre 0 et 120 kHz.

Sur l'intervalle de fréquence étudié, la première bande interdite de charge à 150 kHz n'est pas visible, seule la deuxième bande de fréquence à 80 kHz apparaît. La deuxième bande de fréquences interdites de charge est définie par une fréquence centrale de 80 kHz, une fréquence de la borne supérieure sensiblement supérieure à 90 kHz et une fréquence de la borne inférieure sensiblement inférieure à 70 kHz.

La figure 2e représente un mode de réalisation mettant en oeuvre une condition électrique différente d'une simple mise à la masse 4. En effet, toutes les électrodes 3 sont connectées à la masse : une électrode 3 sur deux est connectée directement à la masse 4 et les autres sont connectées à la masse 4 par l'intermédiaire d'une impédance 5 en d'autres termes les électrodes 3 sont alternativement connectées à la masse 4 et connectées à la masse par l'intermédiaire d'une impédance 5. L'impédance 5 peut comprendre une résistance et/ou une capacité et/ou une inductance. En l'espèce, l'impédance est une capacité.

La figure 2f représente la courbe du signal transmis de la série d'éléments 2 selon le mode de réalisation présenté sur la figure 2e. Sur l'intervalle de fréquence étudié compris entre 0 et 120 kHz, seule la deuxième bande de fréquences interdites apparaît comme dans le mode de réalisation représenté sur la figure 2c. La fréquence de la borne supérieure de la deuxième bande de fréquences interdites est de l'ordre de 85 kHz. La fréquence de la borne supérieure a été déplacée d'environ 5 kHz vers les basses fréquences par rapport au mode de réalisation représenté sur la figure 2c.

La figure 2g représente un mode de réalisation dans lequel une électrode 3 sur deux est connectée à la masse 4 par l'intermédiaire d'une impédance 5, les autres électrodes 3 n'étant pas connectées. L'impédance 5 peut être un circuit électrique comprenant une résistance et/ou une capacité et/ou une inductance. En l'espèce, l'impédance est une capacité.

La figure 2h représente la courbe du signal transmis de la série d'éléments 2 selon le mode de réalisation présenté sur la figure 2g. Sur l'intervalle de fréquence étudiée compris entre 0 et 120 kHz, seule la deuxième bande de fréquences interdites apparaît comme dans le mode de réalisation représenté sur la figure 2c. La fréquence de la borne inférieure de la deuxième bande de fréquences interdites est de l'ordre de 75 kHz. La fréquence de la borne inférieure a été déplacée d'environ 5 kHz vers les hautes fréquences par rapport au mode de réalisation présenté à la figure 2c.

Une connexion à la masse 4 de toutes les électrodes 3 par l'intermédiaire de deux capacités différentes alternativement permet de déplacer en fréquence les bornes supérieure et inférieure de la bande de fréquences interdites de charge simultanément.

De manière générale, les capacités positives agissent sur la fermeture de la bande interdite autrement dit la borne inférieure se déplace vers des fréquences plus élevées et la borne supérieure vers des fréquences plus basses, et inversement pour des capacités négatives.

Les figures 2a à 2h mettent bien en évidence qu'il est possible de déplacer les bornes inférieure et supérieure des bandes de fréquences interdites de charge générées en modifiant la condition électrique imposée.

Selon un aspect de l'invention, le choix du matériau piézoélectrique conditionne les caractéristiques des bandes interdites de charges.

La figure 3a est un tableau qui présente une liste de matériaux ainsi que les valeurs de certaines caractéristiques intrinsèques des matériaux.

Les caractéristiques intrinsèques peuvent comprendre la vitesse de propagation à déplacement électrique constant V^{D} et la vitesse de propagation à champ électrique constant V^{E} d'une onde dans un matériau et le coefficient de couplage électromécanique k.

La vitesse de propagation à déplacement électrique constant est notée V^{D} et elle s'exprime en m.s⁻¹. La vitesse de propagation à champ électrique constant est notée V^{E} et elle s'exprime en m.s⁻¹,

Pour ouvrir une bande de fréquences interdites donnée dans une structure phononique à bande interdite de charge, la vitesse de propagation de l'onde dans le matériau de la structure phononique détermine l'épaisseur du matériau piézoélectrique, l'épaisseur pouvant s'appeler la période spatiale et s'exprimant en micromètre. En d'autres termes, la vitesse de propagation à déplacement électrique constant V^{D} d'une onde dans un matériau et l'épaisseur des éléments 2 déterminent la fréquence de la borne supérieure de la bande de fréquences interdites de charge.

Le coefficient de couplage électromécanique est noté k. C'est une grandeur sans dimension comprise entre 0 et 1 qui peut s'exprimer en pourcentage. Le coefficient de couplage exprime le rendement de conversion de l'énergie électrique d'un matériau piézoélectrique en énergie mécanique, et inversement. Le coefficient de couplage fixe la valeur de la largeur relative en fréquence de la bande interdite de charge.

Ainsi, pour ouvrir une bande de fréquences interdites de charge ayant une fréquence centrale de 500 MHz à partir d'une série de dix éléments 2 comprenant du nitrure d'aluminium, l'épaisseur des éléments 2 est fixée à 10,4 µm. Alors que pour ouvrir cette même bande de fréquences interdites de charge à partir d'une série de 10 éléments 2 comprenant du PMN-28PT une épaisseur de 2,5 µm est suffisante.

Les figures 3b à 3e représentent les courbes calculées du signal transmis représentative des quatre matériaux piézoélectriques listés, respectivement AIN, une céramique PMN-34,5PT, une céramique PZ29 et un monocristal PMN-28PT.

Pour réaliser ces courbes, on réalise une série comprenant dix éléments 2, sous forme de couches d'un des matériaux piézoélectriques présentés sur la figure 3a. On entend par couche une structure géométrique dans laquelle les deux dimensions de la base sont bien supérieures à la hauteur. L'ensemble des dix éléments 2 comprend en outre des électrodes 3 disposées entre deux éléments 2 piézoélectriques. La polarisation de tous les éléments 2 est dans le même sens. Toutes les électrodes 3 sont connectées directement à la masse 4.

La figure 3b est une courbe calculée du signal transmis correspondant à une série de dix éléments 2 comprenant du nitrure d'aluminium ou AIN. La vitesse de propagation V^{D} d'une onde dans le nitrure d'aluminium est de 10641 m.s⁻¹, une épaisseur ou période spatiale des éléments 2 de 10,4 microns est nécessaire pour générer une bande de fréquences interdites de charge autour d'une fréquence de 500 MHz. La courbe du signal transmis de l'AIN présente une bande de fréquences interdites de charge comprise entre 490 et 510 MHz, la bande interdite de charge atteint un minimum de - 8 dB.

La figure 3c est une courbe calculée du signal transmis correspondant à une série d'éléments 2 comprenant la céramique PMN-34,5PT Pb(Mg_{1/2}Nb_{2/3}O₃)-34,5 PbTiO₃ a une vitesse de propagation V^{D} de 3504 m.s⁻¹. L'épaisseur ou la période nécessaire pour générer une bande de fréquences interdites de charge autour de 500 MHz est de 3,1 microns. La courbe du signal transmis présente une bande de fréquences interdites de charge comprise entre 449 et 551 MHz, la bande interdite de charge atteint un minimum de - 40 dB.

La figure 3d est une courbe calculée du signal transmis correspondant à une série d'éléments 2 comprenant du PZ29. Le PZ29 a une vitesse de propagation V^{D} de 3840 m.s⁻¹. L'épaisseur ou la période spatiale nécessaire pour générer une bande de fréquences interdites de charges autour de 500 MHz est de 3,2 microns. La courbe du signal transmis présente une bande de fréquences interdites de charge comprise entre 400 et 600 MHz, la bande interdite de charge atteint un minimum de - 75 dB.

La figure 3e est une courbe calculée du signal transmis correspondant à une série d'éléments 2 comprenant 72Pb(Mg_{1/2}Nb_{2/3}O₃) et du 28PbTiO₃ ou un monocristal PMN-28PT. Le monocristal PMN-28PT a une vitesse de propagation V^{D} de 3424 m.s⁻¹. L'épaisseur ou la période nécessaire pour générer une bande de fréquences interdites de charges autour de 500 MHz est de 2,5 microns soit quatre fois moins grande que l'épaisseur dans le cas de l'AIN. La courbe du signal transmis présente une bande de fréquences interdites de charge comprise entre 321 et 679 MHz, la bande interdite de charge atteint un minimum de -120 dB.

Des figures 3b à 3e, il est possible de conclure que le niveau d'atténuation ainsi que la largeur en fréquence de la bande interdite de charge sont fonction du matériau choisi pour réaliser la série d'éléments 2 piézoélectriques.

Dans un autre mode de réalisation, l'ensemble d'éléments 2 comprend un sous-ensemble d'éléments 2bis comprenant différents matériaux, le sous-ensemble 2 bis étant répété périodiquement.

La figure 4a représente une structure 1 comprenant un-sous ensemble 2bis répété sept fois comprenant deux matériaux piézoélectriques différents. En l'espèce, le premier matériau monocristallin piézoélectrique comprend du Pb(Mg_{1/2}Nb_{2/3}O₃) et du PbTiO₃ ou PMN-28PT et un deuxième matériau comprend du nitrure d'aluminium ou AIN. Les éléments 2 ayant une forme de tronçons de forme cylindriquique de 1 cm de diamètre et de 1 cm de hauteur.

Les éléments 2 sont connectés entre eux par l'intermédiaire d'électrodes 3 et polarisés perpendiculairement aux électrodes 3. En l'espèce, les polarisations de deux éléments 2 sont dans la même sens et le dispositif est en circuit ouvert, autrement dit, aucune des électrodes 3 n'est connectée à la référence électrique 4.

La figure 4d est une représentation graphique du signal transmis en décibel d'une onde acoustique à l'intérieur de la série d'éléments 2 telle que décrite sur la figure 4a en fonction de la fréquence, l'intervalle de fréquences étudié étant compris entre 0 et 200 kHz. Une bande de fréquence interdite apparaît, elle est centrée à environ 140 kHz, la bande interdite présente une largeur en fréquences d'environ 25 kHz et atteint un minimum de -13 dB. La bande interdite correspond à une bande de fréquences interdites de Bragg.

La figure 4b représente une structure 1 comprenant un ensemble de sept éléments 2 mécaniquement connectés comprenant un même matériau monocristallin piézoélectrique comprenant du Pb(Mg_{1/2}Nb_{2/3}O₃) et du PbTiO₃ ou PMN-28PT. Les éléments 2 ayant une forme de tronçons de forme cylindrique 1 cm de diamètre et de 1 cm de hauteur. Les éléments 2 sont connectés entre eux par l'intermédiaire d'électrodes 3 et polarisés perpendiculairement aux électrodes 3. En l'espèce, les polarisations de deux éléments 2 sont dans la même sens et le dispositif est en circuit fermé, autrement dit, toutes les électrodes 3 sont connectées directement à la référence électrique 4.

La figure 4e est une représentation graphique du signal transmis en décibel d'une onde acoustique à l'intérieur de la série d'éléments 2 telle que décrite sur la figure 4b en fonction de la fréquence, l'intervalle de fréquences étudié étant compris entre 0 et 200 kHz. Une bande de fréquences interdites apparaît, elle est centrée à environ 140 kHz, la bande interdite présente une largeur en fréquences d'environ 100 kHz et atteint un minimum de -83 dB. Cette bande interdite est une bande de fréquences interdites de charge.

La figure 4c représente une structure 1 comprenant un sous ensemble 2bis répété sept fois de deux matériaux piézoélectriques différents. En l'espèce, un premier matériau piézoélectrique comprend du Pb(Mg_{1/2}Nb_{2/3}O₃) et du PbTiO₃ ou PMN-28PT et un deuxième matériau comprend de nitrure d'aluminium AIN. Les éléments 2 ayant une forme de tronçon de forme cylindrique de 1 cm de diamètre et de 1 cm de hauteur. Les éléments 2 sont connectés entre eux par l'intermédiaire d'électrodes 3 et polarisés perpendiculairement aux électrodes 3. En l'espèce, les polarisations de deux éléments 2 sont dans la même sens et le dispositif est en circuit fermé, autrement dit, toutes les électrodes 3 sont connectées à la référence électrique 4.

La figure 4f est une représentation graphique du signal transmis en décibel d'une onde acoustique à l'intérieur de la série d'éléments 2 telle que décrite sur la figure 4c en fonction de la fréquence, l'intervalle de fréquences étudié étant compris entre 0 et 200 kHz. Une bande de fréquences interdites apparaît, elle est centrée à environ 100 kHz, la bande interdite présente une largeur en fréquence d'environ 100 kHz et atteint un minimum de -114 dB.

Les figures 4a à 4f permettent de comparer trois structures 1 comprenant sept éléments 2. En l'espèce, les éléments 2 des figures 4a et 4c comprennent un sous-ensemble 2bis comprenant une alternance de PMN-28PT et d'AIN et les éléments 2 de la figure 4b comprennent uniquement du PMN-28PT.

Cette bande de fréquences interdites de la figure 4f, correspondant au mode de réalisation de la figure 4c, cumule les effets de la bande de fréquences interdite de Bragg générées par la périodicité provenant de l'alternance des matériaux et d'une bande interdite de charge générée par l'imposition d'une condition électrique. Le cumul des effets peut être optimisé selon les caractéristiques de la bande de fréquences interdites que l'on souhaite obtenir. Par ailleurs, il est possible d'ouvrir ou de fermer la bande interdite en modifiant la condition électrique imposée.

L'intégration d'une structure 1 phononique à bande de fréquences interdites de charge, selon un aspect de l'invention, à un dispositif acoustique existant tel que les résonateurs de type BAW et les résonateurs comprenant un dispositif à cavité résonante apporte une valeur ajoutée.

Comparativement aux filtres à ondes de surface appelés SAW ou Surface Acoustic Wave en langue anglaise, les résonateurs à ondes acoustiques de volume ou BAW permettent de réaliser des filtres ayant des propriétés particulièrement intéressantes en termes de tenue en puissance et d'intégration sur circuit.

Dans un résonateur de type BAW, une couche piézoélectrique ultra-mince déposée entre deux électrodes excitatrices du matériau piézoélectrique est mise en résonance. Pour conserver un coefficient de qualité élevé, ce résonateur est réalisé sur une membrane ou découplé du substrat par un miroir de Bragg.

La figure 5a représente un résonateur BAW selon l'art connu.

La figure 5b représente un résonateur BAW selon un aspect de l'invention. Le résonateur BAW comprend une couche de matériau piézoélectrique, isolée du substrat par une structure 1 phononique à bande de fréquences interdites de charge ce qui permet de découpler ou de coupler le résonateur avec le substrat. L'intégration d'une structure 1 phononique à bande de fréquences interdites de charge permet d'ajouter une nouvelle fonctionnalité d'interrupteur aux résonateurs BAW.

La figure 6a présente la géométrie d'un dispositif à cavité résonante à base de matériau piézoélectrique, selon l'art connu. Le dispositif servant à l'excitation électrique est inséré dans la cavité, pour créer un résonateur dont les fréquences sont déterminées par la largeur de la cavité. Les frontières de la cavité peuvent aussi être définies par des miroirs de Bragg. En utilisant un miroir de Bragg adéquat, un seul pic de résonance peut être conservé. L'intégration d'une structure 1 phononique à bande de fréquences interdites de charge dans la structure du résonateur comprenant un dispositif à cavité résonante permet de définir la largeur de la cavité et donc sa fréquence de résonance fondamentale.

La figure 6b représente un résonateur comprenant un dispositif à cavité résonante et au moins une structure phononique à bandes interdites de charge. La mise à la masse ou pas des électrodes des éléments piézoélectriques situés aux extrémités de la structure phononique permet de désadapter ou d'adapter l'impédance de la structure phononique vis-à-vis de la cavité et donc de déplacer les limites de la cavité. Ainsi, la largeur de la cavité et donc sa fréquence de résonnance peuvent être ajustées sur toute la bande de fréquence correspondant à la bande interdite de charge de la structure phononique à bande de fréquences interdites de charge.

La figure 6c représente le module de l'admittance électrique d'une cavité résonante en fonction de la fréquence. La fréquence de résonance est de 100 kHz dans le cas d'une cavité résonante selon l'art connu correspondant à la figure 6a. Dans le cas de la figure 6b, la fréquence de résonance augmente quand la largeur de la cavité diminue et inversement ;

La structure 1 phononique à bande de fréquences interdites de charge peut être utilisée pour créer une bande de fréquences interdites autour de 2 kHz pour des applications dans le domaine de la furtivité sous-marine. La structure à bande de fréquences interdites de charge peut aussi être utilisée dans le domaine de la furtivité aérienne en créant des bandes de fréquences interdites autour d'une fréquence adaptée. La figure 7 représente un tableau comprenant une liste de matériaux piézoélectriques ainsi que leurs caractéristiques intrinsèques et les paramètres permettant de générer une bande de fréquences interdites autour 2 kHz.

Le tableau de la figure 7 montre qu'avec le monocristal PMN-28PT, une épaisseur de 0,63 m est nécessaire pour générer une bande de fréquences interdites autour de 2 kHz. Dans ces conditions, la largeur relative de la bande de fréquences interdites est de 72%. L'utilisation de polymères piézoélectriques ou de matériaux sans plomb avec des vitesses de propagation plus faibles que celle des autres matériaux piézoélectriques permettrait d'envisager des épaisseurs de couche plus faibles. Un élément 2 de 0,22 m d'épaisseur comprenant du PVDF permet de générer une bande de fréquences interdites de charge autour de 2 kHz. Cependant la largeur relative de la bande de fréquence interdite est de 0,6 %. L'utilisation de co polymère comprenant du poly(vinylidene fluoride) et du trifluoroethylène P(VDF-TrFE) avec une constante de couplage de 65% permet d'augmenter la largeur de bande interdite. Il est donc nécessaire pour les applications de furtivité sous-marine de réaliser un compromis entre un coefficient de couplage élevé permettant une largeur relative de bande relativement importante et une épaisseur de matériau raisonnable. Une application des structures 1 phononiques à bande de fréquences interdites de charge consiste en l'isolation de structures vibrantes.

La figure 8a illustre cette application. L'idée est d'utiliser une structure 1 phononique à bande de fréquences interdites de charge afin de découpler ou d'isoler une structure vibrante d'une autre structure, susceptible d'émettre des rayonnements, la référence CPIBC désignant le cristal phononique à bande interdite de charge.

Si une seule structure 1 phononique à bande de fréquences interdites de charge est utilisée, l'énergie de vibration est alors réfléchie vers la structure vibrante et l'amplitude de la vibration augmente alors. Un matériau amortissant peut être disposé dans la structure vibrante afin d'absorber l'énergie réfléchie et d'éviter l'augmentation de l'amplitude de vibration.

Une autre application de la structure 1 phononique à bande de fréquences interdites de charge consiste au transfert d'énergie d'une structure vibrante à une autre. La figure 8b illustre cette application. L'idée est d'utiliser la structure 1 phononique à bande de fréquences interdites de charge afin de créer un transfert irréversible de l'énergie vibratoire d'une structure vers une autre. Lorsque deux structures A et B sont couplées, sur un cycle, une partie de l'énergie vibratoire passe de A vers B puis de B vers A. En utilisant une fonction interrupteur de la structure phononique 1, l'énergie peut être transférée uniquement dans un sens de A vers B, par exemple.

Le demandeur a validé le concept de la présente invention en effectuant un ensemble d'expériences décrites ci-après, avec un matériau de céramique PZ29 de longueur 2 cm pour chaque élément.

La figure 9 illustre le passage des électrodes en circuit ouvert à des électrodes en court-circuit permettant de créer une bande interdite, sur l'intervalle noté [F_{inf}, Fₛᵤₚ].

Les figures 10 et 11 illustrent respectivement l'évolution de la bande de fréquence en fonction de la fréquence et l'évolution du nombre d'onde normalisé. Les courbes C₁₀ₐ et C₁₁ₐ sont relatives à la configuration en mode circuit ouvert, les courbes C_{10b} et C_{11b} sont relatives à la configuration en mode court-circuit.

Pour explorer davantage les potentialités du dispositif de la présente invention, les Demandeurs ont placé une capacité à la place du court-circuit, comme représenté en figure 12. Dans ce cas, la borne supérieure de la bande interdite ne varie pas (Fₛᵤₚ). En revanche la borne inférieure de la bande interdite varie de F_{inf} (capacité infinie = court circuit) à Fₛᵤₚ (capacité nulle = circuit ouvert), comme illustré en figure 13.
Une capacité négative permet d'obtenir une bande interdite sur l'intervalle [Fₛᵤₚ, F] avec F> Fₛᵤₚ.

Une démarche similaire a été effectuée en plaçant cette fois un court-circuit sur une électrode sur deux et en plaçant une capacité variable sur une électrode sur deux, comme représenté en figure 14. Dans ce cas, la borne inférieure de la bande interdite F_{inf} ne varie pas mais la borne supérieure de la bande interdite varie de F_{inf} à Fₛᵤₚ, comme illustré en figure 15.
Une capacité négative permet de modifier de même la bande interdite.

En combinant les deux dispositifs précédents, on arrive à modifier les bornes inférieures et supérieures de la bande interdite, de façon indépendante, dont l'illustration est donnée en figure 16.
On peut jouer sur les capacités C1 et C2 en vue de modifier la largeur de la bande interdite sans modifier sa fréquence centrale (figure 17) ou bien modifier la fréquence centrale de la bande interdite sans modifier sa largeur (figure 18).

## Revendications

1. Dispositif acoustique comprenant une structure (1) périodique phononique à bande réglable de fréquences interdites de charge, **caractérisé en ce qu'**il comprend :
- un ensemble d'éléments (2) piézoélectriques connectés mécaniquement en série, un élément (2) piézoélectrique comprenant un matériau piézoélectrique et étant polarisé selon une direction de polarisation (dₚₒₗ), les directions de polarisation de deux éléments (2) successifs étant parallèles ou anti-parallèles et lesdits éléments (2) piézoélectriques étant dirigés selon une direction principale (d_{princ});
- un ensemble d'électrodes (3) disposées entre deux éléments piézoélectriques adjacents (2) et perpendiculaires à la direction principale ;
- l'ensemble desdites électrodes comprenant au moins un sous-ensemble d'électrodes connectées de façon périodique à une référence électrique extérieure (4) ;
- ledit sous-ensemble d'électrodes étant connecté à la référence électrique (4) par l'intermédiaire d'un circuit électrique (5),
la bande réglable de fréquences interdites apparaissant lorsqu'un déplacement de charges électriques provient d'une référence électrique extérieure via une électrode dudit ensemble d'électrodes.

2. Dispositif acoustique selon la revendication 1 adapté pour commander le circuit électrique à partir de données reçues d'un capteur extérieur.

3. Dispositif selon l'une des revendications précédentes dans lequel les éléments (2) piézoélectriques comprennent un même matériau piézoélectrique.

4. Dispositif acoustique selon l'une des revendications précédentes comprenant en outre au moins un élément (2) diélectrique.

5. Dispositif acoustique selon l'une des revendications précédentes dans lequel la référence électrique (4) est la masse.

6. Dispositif acoustique selon l'une des revendications précédentes dans lequel la référence électrique est une source (4) de tension extérieure.

7. Dispositif acoustique selon l'une des revendications précédentes dans lequel les éléments (2) ont une forme de plaques ou ont une forme de tronçons.

8. Dispositif acoustique selon l'une des revendications précédentes dans lequel la direction de polarisation est identique à la direction principale.

9. Résonateur BAW comprenant un dispositif acoustique selon les revendications 1 à 8.

10. Dispositif à cavité résonante comprenant un dispositif acoustique selon les revendications 1 à 8.

11. Dispositif d'isolation d'une structure vibrante comprenant un dispositif acoustique selon les revendications 1 à 8.

12. Dispositif d'isolation selon la revendication 11 qui comprend en outre une structure d'amortissement.

13. Dispositif de transfert d'énergie d'une première structure vibrante vers une deuxième structure vibrante comprenant un dispositif acoustique selon les revendications 1 à 8.

## Patentansprüche

1. Akustische Vorrichtung, die eine phononische periodische Struktur (1) mit regelbarer Ladungsbandlücke umfasst, **dadurch gekennzeichnet, dass** sie Folgendes umfasst:
- einen Satz von mechanisch in Serie verbundenen piezoelektrischen Elementen (2), wobei ein piezoelektrisches Element (2) ein piezoelektrisches Material umfasst und in einer Polarisationsrichtung (dₚₒₗ) polarisiert ist, wobei die Polarisationsrichtungen von zwei aufeinander folgenden Elementen (2) parallel oder antiparallel sind und die piezoelektrischen Elemente (2) gemäß einer Hauptrichtung (d_{princ}) geleitet werden;
- einen Satz von Elektroden (3), die zwischen zwei benachbarten piezoelektrischen Elementen (2) und lotrecht zur Hauptrichtung angeordnet sind;
- wobei der Elektrodensatz wenigstens einen Teilsatz von Elektroden umfasst, die auf periodische Weise mit einer externen elektrischen Referenz (4) verbunden sind;
- wobei der Elektrodenteilsatz mit der elektrischen Referenz (4) über einen elektrischen Stromkreis (5) verbunden ist,
wobei die regelbare Bandlücke erscheint, wenn eine Bewegung von elektrischen Ladungen von einer externen elektrischen Referenz über eine Elektrode des Elektrodensatzes stammt.

2. Akustische Vorrichtung nach Anspruch 1, ausgelegt zum Steuern des elektrischen Stromkreises auf der Basis von von einem externen Sensor empfangenen Daten.

3. Vorrichtung nach einem der vorherigen Ansprüche, bei der die piezoelektrischen Elemente (2) ein selbes piezoelektrisches Material umfassen.

4. Akustische Vorrichtung nach einem der vorherigen Ansprüche, die ferner wenigstens ein dielektrisches Element (2) umfasst.

5. Akustische Vorrichtung nach einem der vorherigen Ansprüche, wobei die elektrische Referenz (4) Masse ist.

6. Akustische Vorrichtung nach einem der vorherigen Ansprüche, wobei die elektrische Referenz eine externe Spannungsquelle (4) ist.

7. Akustische Vorrichtung nach einem der vorherigen Ansprüche, bei der die Elemente (2) die Form von Platten oder die Form von Abschnitten haben.

8. Akustische Vorrichtung nach einem der vorherigen Ansprüche, bei der die Polarisationsrichtung mit der Hauptrichtung identisch ist.

9. BAW-Resonator, der eine akustische Vorrichtung nach den Ansprüchen 1 bis 8 umfasst.

10. Vorrichtung mit Resonanzhohlraum, die eine akustische Vorrichtung nach den Ansprüchen 1 bis 8 umfasst.

11. Vorrichtung zum Isolieren einer vibrierenden Struktur, die eine akustische Vorrichtung nach den Ansprüchen 1 bis 8 umfasst.

12. Isolationsvorrichtung nach Anspruch 11, die ferner eine Dämpfungsstruktur umfasst.

13. Vorrichtung zum Übertragen von Energie von einer ersten vibrierenden Struktur zu einer zweiten vibrierenden Struktur, die eine akustische Vorrichtung nach den Ansprüchen 1 bis 8 umfasst.

## Claims

1. An acoustic device comprising an adjustable charge band gap phononic periodic structure (1), **characterised in that** it comprises:
- a set of piezoelectric elements (2) mechanically connected in series, a piezoelectric element (2) comprising a piezoelectric material and being polarised in a polarisation direction (dₚₒₗ), the polarisation directions of two successive elements (2) being parallel or anti-parallel and said piezoelectric elements (2) being directed in a main direction (d_{princ});
- a set of electrodes (3) disposed between two adjacent piezoelectric elements (2) and perpendicular to the main direction;
- the set of said electrodes comprising at least one sub-set of electrodes connected to an external electric reference (4) at regular intervals;
- said sub-set of electrodes being connected to the electric reference (4) by means of an electric circuit (5),
the adjustable band gap occurring when a displacement of electric charges originates from an external electric reference via an electrode of said set of electrodes.

2. The acoustic device according to claim 1, adapted to control the electric circuit on the basis of data received from an external sensor.

3. The device according to any one of the preceding claims, wherein the piezoelectric elements (2) comprise the same piezoelectric material.

4. The acoustic device according to any one of the preceding claims, further comprising at least one dielectric element (2).

5. The acoustic device according to any one of the preceding claims, wherein the electric reference (4) is the ground.

6. The acoustic device according to any one of the preceding claims, wherein the electric reference is an external voltage source (4).

7. The acoustic device according to any one of the preceding claims, wherein the elements (2) are in the form of plates or in the form of segments.

8. The acoustic device according to any one of the preceding claims, wherein the polarisation direction is identical to the main direction.

9. A BAW resonator comprising an acoustic device as claimed in claims 1 to 8.

10. A resonant cavity device comprising an acoustic device according to claims 1 to 8.

11. A device for isolating a vibrating structure comprising an acoustic device according to claims 1 to 8.

12. The isolation device according to claim 11, further comprising a damping structure.

13. A device for transferring energy from a first vibrating structure to a second vibrating structure comprising an acoustic device according to claims 1 to 8.
